# EUROPEAN PATENT APPLICATION

(11) **EP 4 718 208 A1**
(43) Date of publication of application: **01.04.2026**
(21) Application number: 23938465.4
(22) Date of filing: 23.05.2023
(51) Int. Cl.: G06F 1/20

(54) **METHOD FOR COOLING COMPUTER SYSTEM, AND LIQUID IMMERSION TANK**

(71) Applicant: Zyrq Inc., Nagaoka-shi, Niigata 940-0061 (JP)
(72) Inventor: SAITO, Motoaki, Tokyo 106-0043 (JP)
(74) Representative: Goddar, Heinz J.
(86) International application number: PCT/JP2023/019173
(87) International publication number: WO 2024/241500

(57) **Abstract**

To provide an improved cooling method and a liquid cooling tank for applying liquid-immersion cooling to increasingly three-dimensionally complex computer systems. The computer system, including two or more heat-generating elements, is divided into a first segment including one or more first heat-generating elements and a second segment including one or more second heat-generating elements. The first segment is waterproofed by being covered with a waterproof film or a waterproof bag. The waterproofed first segment is electrically connected to the unwaterproofed second segment. The waterproofed first segment is immersed in a first liquid cooling tank containing a first refrigerant. The unwaterproofed second segment is immersed in a second liquid cooling tank containing a second refrigerant different from the first refrigerant.

## Description

### BACKGROUND

The present invention relates to a method for cooling a computer system and a liquid cooling tank, and more specifically to the method for cooling the computer system and the liquid cooling tank by immersing it in a refrigerant, while the computer system represents a supercomputer, a data center, an artificial intelligence processing system, a quantum computing system, a cryptographic processing system, a cryptographic processing system, or a blockchain processing system that requires high performance, stable operation, or low-power-consumption operation, and generates a large amount of heat.

One of the biggest challenges determining the performance limits of computer-related equipment in recent years is power consumption. The importance of research into thrifty power consumption, particularly in supercomputers, is already widely recognized. Speed performance per watt (Flops/W) is one index for evaluating supercomputers. Cooling is estimated to consume more than 30% of the total power consumed by a data center, generating a growing demand for power reduction through improved cooling efficiency.

Conventional cooling methods become incapable of cooling the data centers in the summer due to recent global warming and extreme heat caused by weather anomalies. There is an urgent need to improve the cooling capacity of existing systems.

The processing power of data centers and computer systems must be increased exponentially in terms of the rapid growth of artificial intelligence processing, the increasing need for encryption processing, the rapid increase in cryptocurrency mining as a key example of blockchain processing, and the development of the metaverse, which is broadly predicted to grow rapidly. There is a remarkably increasing demand for enhanced cooling capacity.

Conventionally, air-cooled and liquid-cooled types are used to cool supercomputers and data centers. The liquid-cooled type is generally considered to exhibit better cooling efficiency because it uses liquid whose heat transference is significantly better than air. For example, the "TSUBAME-KFC" supercomputer, developed by the Tokyo Institute of Technology, achieved 4.50 G Flops/W using a synthetic oil immersion cooling system. It ranked first in the "Green500 List" of supercomputers published in November 2013 and June 2014.

On the other hand, a liquid immersion cooling system has been proposed to use fluorocarbon refrigerants rather than synthetic or mineral oils. Specifically, the examples use a fluorocarbon refrigerant (a hydrofluoroether (HFE) compound known as 3M Company's product name "Novec (trademark of 3M Company, applied uniformly hereinafter) 7100," "Novec 7200," or "Novec 7300"). (For example, Japanese Unexamined Patent Application Publication No. 2013-187251, and Japanese Translation of PCT International Application Publication No. JP-T-2012-527109).

In addition to these, since 2014, the inventor has developed a new liquid immersion cooling system and a series of related technologies for directly cooling electronic apparatuses by supplying the open space of a cooling tank with a hardly evaporable refrigerant containing a fully fluorinated substance as a main component. (For example, Japanese Patent No. 5853072).

However, PFAS (perfluoroalkyl substances and polyfluoroalkyl substances), including all of these fluorocarbon-based refrigerants, have long been known to have adverse effects on humans, crops, and the natural environment. In December 2022, the world's largest manufacturer announced that it would completely cease production by the end of 2025. In Europe, both the production and use of PFAS are expected to be banned by law within the next few years.

There is a need for a new immersion cooling method that is more affordable and can be used widely worldwide without the use of any harmful compounds such as PFAS as a refrigerant, and excels more highly in the cooling capacity compared to immersion cooling methods using PFAS as a refrigerant, for example.

There is a typical example of a cooling method that does not use harmful compounds such as PFAS as a refrigerant and can use ordinary water (tap water or industrial water) rather than pure water. Specifically, the proposed cooling method places a semiconductor chip mounted on a printed circuit board in a flexible bag, immerses the bag in a container filled with water as a refrigerant, and closely attaches the bag to the semiconductor device by shrinking and deforming the bag due to a pressure difference between the inside and outside of the bag when the bag is filled with water or the pressure inside the bag is reduced. (For example, Japanese Patent No. 2804640).

Still another cooling method using water is proposed: a natural water-cooled computer, which uses river, lake, seawater, or tap water as a cooling source to directly cool the computer. Specifically, this cooling method immerses a computer in water by coating the printed circuit board surface with parylene resin. (For example, Ikki Fujiwara, et al. "The First Step Towards Direct Natural Water-Cooled Computers." Information Processing Society of Japan, Technical Report, High Performance Computing (HPC), 2017-HPC-158(5), March 1, 2017. pp. 1-5. URL:http://research.nii.ac.jp/~koibuchi/pdf/ikki-sighpc158.pdf

Yet another cooling method is proposed to completely coat the entire printed circuit board with an ultra-nanohydrophobic thin film coating using silicon compound nanoparticles, make an electronic apparatus excellent in waterproof and moisture-resistant properties, and immerse it in water. (For example, U.S. Patent No. 10717881).

### SUMMARY

The cooling system, disclosed in Ikki Fujiwara, et al. "The First Step Towards Direct Natural Water-Cooled Computers." Information Processing Society of Japan, Technical Report, High Performance Computing (HPC), 2017-HPC-158(5), March 1, 2017. pp. 1-5. URL:http://research.nii.ac.jp/~koibuchi/pdf/ikki-sighpc158.pdf, completely coats the whole of electronic components and printed circuit boards with an electrically non-conductive, water-impermeable parylene thin film coating. The electronic components and printed circuit boards coated with the parylene thin film coating are then entirely immersed in water or seawater. The apparatus is cooled using the low temperature of the water or seawater that comes into contact with the entire parylene thin film coating.

Similarly, the cooling system, disclosed in U.S. Patent No. 10717881, also employs a system that completely coats the whole of the electronic components and the electronic printed circuit board with an ultra-nano hydrophobic thin film coating using electrically non-conductive, water-impermeable silicon compound nanoparticles and immerses the whole of the electronic components and the electronic printed circuit board coated with the hydrophobic coating film in water to cool the apparatus using the low temperature of the water that comes into contact with the entire hydrophobic thin film coating.

The water-cooling method, disclosed in Patent No. 2804640, cools a semiconductor device by placing it in a flexible bag and immersing it in a refrigerant such as water.

The computer system used for supercomputers or data centers, for example, generally includes an electronic printed circuit board and various electronic components (CPU (Central Processing Unit) and/or GPU (Graphics Processing Unit), highspeed memory, chipset, power supply-related components such as FETs (Field Effect Transistors), electrolytic capacitors, network units, bus switch units, or SSDs (Solid State Drives), for example) mounted on the electronic printed circuit board, and a PSU (Power Supply Unit) for supplying power to the electronic components.

Recent computer systems use electronic printed circuit boards that are mounted with various electronic components and PSUs and are formed into complex three-dimensional shapes. Considerable technical challenges are expected to establish a technology that coats complex three-dimensional computer systems with flawless complete thin films.

In terms of a method of cooling the computer system by placing it in a flexible bag and immersing it in a coolant such as water, it is favorable to closely attach the exterior of the computer system to the interior of the bag as tightly as possible and thereby enhance heat transfer from the computer system to the surrounding refrigerant. However, it is expected to be technically more difficult to satisfy this requirement as the 3D structure of computer systems becomes increasingly complex.

Therefore, it is an object of the present invention to solve the above-mentioned problems of the prior art and to provide an improved cooling method and a liquid cooling tank for applying liquid-immersion cooling to increasingly three-dimensionally complex computer systems.

To solve the above-described problem, one aspect of the present invention provides a method for cooling the computer system. The computer system, including two or more heat-generating elements, is divided into a first segment including one or more first heat-generating elements and a second segment including one or more second heat-generating elements. The first and second segments are electrically connected. The first segment is immersed in a first liquid cooling tank containing a first refrigerant. The second segment is immersed in a second liquid cooling tank containing a second refrigerant different from the first refrigerant.

Another aspect of the present invention provides the method for cooling the computer system. The computer system, including two or more heat-generating elements, is divided into a first segment including one or more first heat-generating elements and a second segment including one or more second heat-generating elements. The first segment is waterproofed by being covered with a waterproof film or a waterproof bag. The waterproofed first segment is electrically connected to the unwaterproofed second segment. The waterproofed first segment is immersed in the first liquid cooling tank containing a first refrigerant. The unwaterproofed second segment is immersed in a second liquid cooling tank containing a second refrigerant different from the first refrigerant.

According to a preferred embodiment of the above-described cooling method, the first segment may include an electronic printed circuit board where various electronic components are mounted. The first heat-generating element may include one or more CPUs or GPUs. The second segment may include a power supply unit (PSU). A second heat-generating element may include one or more voltage converters or power semiconductors.

According to a preferred embodiment of the above-described cooling method, the first refrigerant may be water. The second coolant may be a non-conductive synthetic oil, mineral oil, or silicone oil.

According to a preferred embodiment of the above-described cooling method, a supply terminal of the waterproofed first segment and a supply terminal of the unwaterproofed second segment may be electrically connected via a conductive path. The conductive path may be a bus bar or an electrical cable.

According to a preferred embodiment of the above-described cooling method, the first liquid cooling tank and the second liquid cooling tank are each formed of a bottom wall and one or more side walls. The second liquid cooling tank may be placed in the first liquid cooling tank. The first liquid cooling tank may be formed of a bottom wall and one or more side walls. The second liquid cooling tank may be formed by placing a partition wall in the first liquid cooling tank.

According to a preferred embodiment of the above-described cooling method, the first liquid cooling tank and the second liquid cooling tank may be each formed of a bottom wall and one or more side walls. The first liquid cooling tank and the second liquid cooling tank may be positioned so that one side wall of the second liquid cooling tank and one side wall of the first liquid cooling tank share one partition wall or adjoin.

According to a preferred embodiment of the above-described cooling method, a heat dissipation mechanism for absorbing heat from the second refrigerant in the second liquid cooling tank may be placed in the first liquid cooling tank. In this case, the heat dissipation mechanism may be a heat sink thermally connected to one or more side walls or partition walls of the second liquid cooling tank.

According to a preferred embodiment of the above-described cooling method, the heat dissipation mechanism may be a radiator provided for a second refrigerant route connecting a refrigerant inlet and a refrigerant outlet provided for the second liquid cooling tank. The second refrigerant route may be provided with a second pump for forcibly circulating the second refrigerant.

According to a preferred embodiment of the above-described cooling method, a heat exchanger may be provided for a first refrigerant route connecting a refrigerant inlet and a refrigerant outlet provided for the first refrigerant tank. The first refrigerant route may be provided with a first pump for forcibly circulating the first refrigerant.

Still another aspect of the present invention provides a liquid cooling tank that cools a first segment, including one or more first heat-generating elements, and a second segment, including one or more second heat-generating elements, using different refrigerants. Each segment is divided from the computer system including two or more heat-generating elements. The liquid cooling tank includes the first liquid cooling tank for containing a first refrigerant; the second liquid cooling tank for containing a second refrigerant different from the first refrigerant; and a heat dissipation mechanism that is placed in the first liquid cooling tank and absorbs heat from the second refrigerant in the second liquid cooling tank.

It may also be advantageous to divide the computer system into three or more segments and immerse each segment separately in two or more liquid cooling tanks containing two or more different refrigerants. For example, it may also be advantageous to divide the computer system into a first segment (CPU printed circuit board), a second segment (PSU), and a third segment (SSD printed circuit board), immerse the waterproofed first and third segments in the first liquid cooling tank containing the first refrigerant (e.g., water), and immerse the second segment in the second liquid cooling tank containing the second refrigerant (such as non-conductive synthetic oil, mineral oil, or silicone oil). The first through third segments may be immersed in first through third liquid cooling tanks, respectively. In this case, the first and third liquid cooling tanks may contain a first refrigerant (water). The second liquid cooling tank may contain a second refrigerant (non-conductive synthetic oil, mineral oil, or silicone oil). The first through third segments may be immersed in the first through third liquid cooling tanks, respectively containing the first through third refrigerants of different types or natures.

The computer system including two or more heat-generating elements can be divided into a first segment containing one or more first heat-generating elements and a second segment containing one or more second heat-generating elements. The first and second segments can be cooled with different refrigerants, separately. The computer system can be created by separately applying different cooling requirements, based on different types of refrigerants, to the first and second segments. For example, the computer system can be divided into a segment that is relatively easy to waterproof and a segment that is relatively hard to waterproof. The former is waterproofed and then can be cooled by being immersed in a liquid cooling tank containing water. The latter can be cooled without waterproofing by being immersed in a liquid cooling tank containing a refrigerant such as non-conductive synthetic oil, mineral oil, or silicone oil. Even if the computer system becomes more three-dimensionally complex, it can be divided into segments in which one is relatively flat structured and is easy to waterproof stably, and the other is relatively flat structured and is hard to waterproof stably, for example. Different liquid immersion cooling methods using different refrigerants can be applied to these different segments.

Water can surely be used as the first refrigerant if the first segment is waterproofed by being covered with a waterproof coating or bag. The second refrigerant can be surely available as a safer, non-conductive synthetic oil, mineral oil, or silicone oil that does not contain harmful compounds such as PFAS.

The computer system can be created by separately applying different cooling requirements, based on different types of refrigerants, to the first and second segments. The liquid cooling tank can be configured to include the first liquid cooling tank for containing a first refrigerant; the second liquid cooling tank for containing a second refrigerant different from the first refrigerant; and a heat dissipation mechanism that is placed in the first liquid cooling tank and absorbs heat from the second refrigerant in the second liquid cooling tank. Then, the heat dissipation mechanism placed outside the second liquid cooling tank can cool the second segment in the second liquid cooling tank by transferring heat from the second refrigerant to the refrigerant in the first liquid cooling tank. The heat dissipation mechanism for cooling the second refrigerant is placed inside the first liquid cooling tank. Heat exchangers, fewer than the liquid cooling tanks, just need to be installed outside the liquid cooling tanks, making it possible to save facilities and space required for installation.

The above and other objects and advantages of the present invention will be more clearly understood through the following description of the embodiments. The embodiments described below are merely examples, and the present invention is not limited thereto.

### BRIEF DESCRIPTION OF THE DRAWINGS

Fig. 1 is a schematic diagram illustrating a cooling method according to one embodiment of the present invention.
Fig. 2 is a schematic diagram illustrating a liquid cooling tank according to one embodiment of the present invention.
Fig. 3 is a schematic diagram illustrating another example of the liquid cooling tank.
Fig. 4 is a schematic diagram illustrating another example of the liquid cooling tank.
Fig. 5 is a diagram illustrating a waterproofed first segment.
Fig. 6 is a diagram illustrating the waterproofed first segment.

### DETAILED DESCRIPTION

The following describes in detail preferred embodiments of the cooling method according to the present invention, based on the drawings.

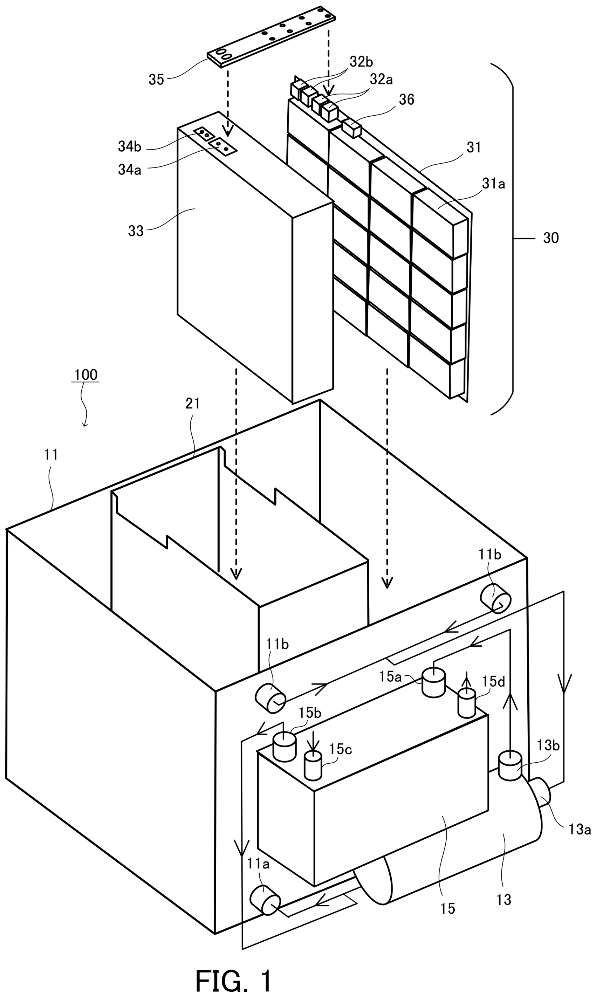

Referring to Fig. 1, a refrigerant tank 100 is configured as a combination of a refrigerant tank 11 and a refrigerant tank 21. In the illustrated example, the refrigerant tank 11 is formed into a rectangular or cubic bath divided by a bottom wall and four side walls. The refrigerant tank 21 is shaped into a rectangular parallelepiped divided by the bottom wall and four side walls. The width and the depth of the refrigerant tank 21 are shorter than those of the refrigerant tank 11. Therefore, the refrigerant tank 21 can be placed inside the refrigerant tank 11. The refrigerant tank 11 corresponds to a first refrigerant tank. The refrigerant tank 21 corresponds to a second refrigerant tank. The refrigerant bath 11 can contain water as a refrigerant. The refrigerant tank 21 can contain non-conductive synthetic oil, mineral oil, or silicone oil as a refrigerant. The refrigerant (water) to be contained in the refrigerant tank 11 corresponds to a first refrigerant. The refrigerant (non-conductive synthetic oil, mineral oil, or silicone oil) to be contained in the refrigerant tank 21 corresponds to a second refrigerant.

A computer system 30 can be divided into an electronic printed circuit board 31, including multiple CPUs or GPUs and various other electronic components mounted on a printed circuit board; and a PSU 33, including one or more voltage converters or power semiconductors. The CPU, GPU, voltage converter, and power semiconductor are merely examples. All of these correspond to heat-generating elements. The electronic printed circuit board 31 corresponds to a first segment separated from the computer system 30. The PSU 33 corresponds to a second segment separated from the computer system 30.

The electronic printed circuit board 31 includes multiple CPUs or GPUs. A heat sink 31a is thermally connected to each CPU or GPU to dissipate heat generated by the CPUs or GPUs. In the illustrated example, CPUs or GPUs are mounted, five rows by four columns, on one side of the printed circuit board. The back surface of the heat sink 31a is thermally connected to each CPU or GPU. The top of the electronic apparatus 31 includes DC voltage input terminals 32a and 32b and a connector terminal 36 for connecting a communication network cable.

The electronic printed circuit board 31 is favorably waterproofed except for the DC voltage input terminals 32a, 32b and the connector terminal 36. As specific examples of waterproofing, one is completely covering the electronic printed circuit board 31 and the heat sink 31a with a parylene thin film coating (Ikki Fujiwara, et al. "The First Step Towards Direct Natural Water-Cooled Computers." Information Processing Society of Japan, Technical Report, High Performance Computing (HPC), 2017-HPC-158(5), March 1, 2017. pp. 1-5. URL:http://research.nii.ac.jp/~koibuchi/pdf/ikki-sighpc158.pdf, for example). Another is completely covering the electronic printed circuit board 31 and the heat sink 31a with an ultra-nanohydrophobic thin film coating using silicon compound nanoparticles (for example, U.S. Patent No. 10717881). The illustrated electronic printed circuit board 31 is formed to carpet the printed circuit board with equally shaped and aligned heat sinks 31a and allows a relatively flat and simple structure to easily apply the stable waterproof treatment. The electronic printed circuit board 31 can be waterproofed using complete film coating such as the parylene thin film coating or the ultra-nanohydrophobic thin film coating. The waterproofed electronic printed circuit board 31 can be immersed in the liquid cooling tank 11 filled with general water for cooling. In the illustrated example, a total of eight electronic printed circuit boards 31, four on each of right and left sides, can be immersed in the liquid cooling tank 11 for cooling (only one electronic printed circuit board is illustrated for convenience).

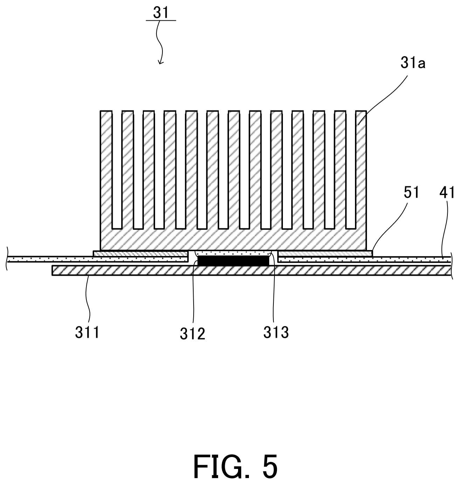

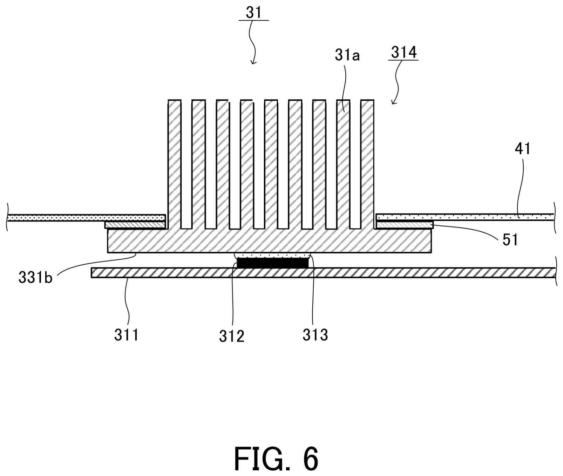

Another favorable example of the waterproofing treatment is to place the electronic printed circuit board 31 in a flexible bag. (For example, Japanese Patent No. 2804640). A more favorable example of the waterproofing treatment is to place the printed circuit board in a special complex configured to enable the heat sink 31a to directly contact the refrigerant (unpublished International Application Nos. PCT/JP2023/13985 and PCT/JP2023/014002, for example). An example of the latter is described below by referencing Figs. 5 and 6.

The PSU 33 includes one or more voltage converters or power semiconductors (unshown) inside a rectangular housing, and includes DC voltage output terminals 34a and 34b on the top of the housing. The internal structure of the housing is more three-dimensional and complex than that of the electronic printed circuit board 31. It seems to be considerably difficult to waterproof the electronic components inside the housing by forming a complete coating, such as a parylene thin film coating or an ultra-nanohydrophobic thin film coating, or by using bags. For this reason, the unwaterproofed PSU 33 is cooled by immersing it in a liquid cooling tank 21 containing non-conductive synthetic oil, mineral oil, or silicone oil. In the illustrated example, two PSUs 33 can be immersed side by side in the liquid cooling tank 21 for cooling (only one PSU is illustrated for convenience).

A bus bar 35 makes an electrical connection between the DC voltage input terminal 32a of the electronic printed circuit board 31 and the DC voltage output terminal 34a of the PSU 33, as well as between the DC voltage input terminal 32b and the DC voltage output terminal 34b (only one bus bar is illustrated for convenience). The DC voltage input terminals 32a and 32b, and the DC voltage output terminals 34a and 34b, correspond to supply terminals. The bus bar 35 corresponds to a conductive path.

The following describes an example of a refrigerant path for cooling the first refrigerant placed in the liquid cooling tank 11. A pump 13 and a heat exchanger 15 are provided for a refrigerant path connecting two refrigerant inlets 11a provided at the bottom of one side-wall of the liquid cooling tank 11 and two refrigerant outlets 11b provided at the top of the same side-wall. A plate-type heat exchanger may be used for the heat exchanger 15. The refrigerant outlet 11b of the liquid cooling tank 11 is connected to the inlet 13a of the pump 13. The outlet 13b of the pump 13 is connected to the cooled refrigerant inlet 15a of the heat exchanger 15. The cooled refrigerant outlet 15b of the heat exchanger 15 is connected to the refrigerant inlet 11a of the liquid cooling tank 11. A chiller (unshown) supplies a cold external refrigerant to the cooling refrigerant inlet 15c of the heat exchanger 15. Heat exchange with the first refrigerant occurs in the heat exchanger 15. The warmed refrigerant is discharged from the cooling refrigerant outlet 15d and is returned to the chiller (unshown). The refrigerant path can be configured using piping. For ease of illustration, the refrigerant path is depicted using arrowed solid lines indicating the refrigerant flow directions.

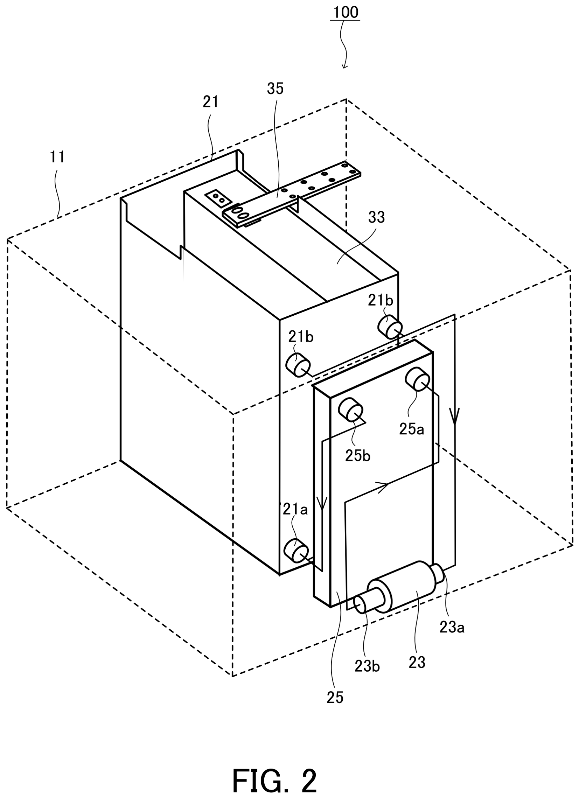

Referencing Fig. 2, the following describes an example of a heat dissipation mechanism for cooling the second refrigerant contained in the liquid cooling tank 21 provided for the liquid cooling tank 100. In the illustrated example, a pump 23 and a radiator 25 are provided for the refrigerant path that connects two refrigerant inlets 21a, placed at the bottom of one side-wall of the liquid cooling tank 21, with two refrigerant outlets 21b placed at the top of the same side-wall. The refrigerant outlet 21b of the liquid cooling tank 21 is connected to an inlet 23a of the pump 23. An outlet 23b of the pump 23 is connected to a refrigerant inlet 25a of the radiator 25. A refrigerant outlet 25b of the radiator 25 is connected to the refrigerant inlet 21a of the liquid cooling tank 21. The pump 23 and the radiator 25 are placed outside the liquid cooling tank 21 and inside the liquid cooling tank 11. The second refrigerant placed in the liquid cooling tank 21 is transported by the pump 23 to the radiator 25 positioned outside the liquid cooling tank 21, and is cooled, while passing through the inside of the radiator 25, by the first refrigerant that surrounds the radiator 25 and absorbs heat from the fin surfaces of the radiator. The second refrigerant is then returned to the liquid cooling tank 21. The radiator is merely an example and may be replaced by a heat exchanger (such as a plate-type heat exchanger).

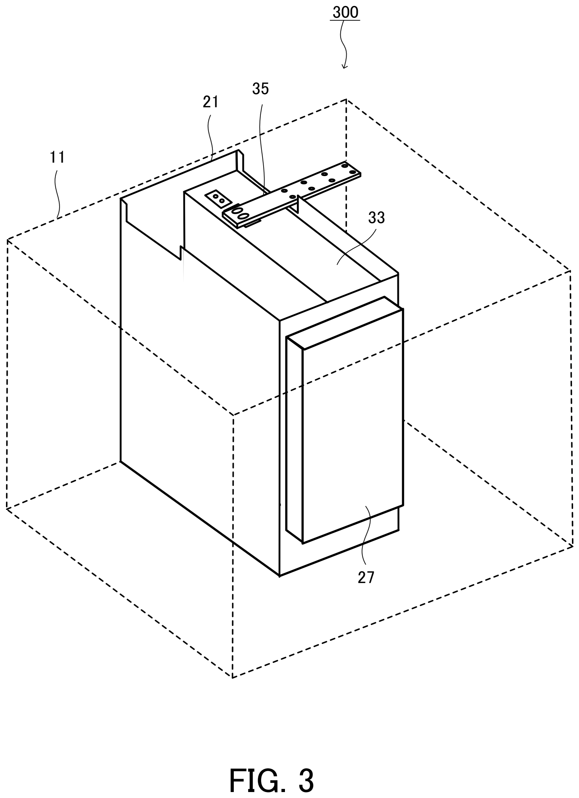

The following describes another example of the heat dissipation mechanism for cooling the second refrigerant contained in the liquid cooling tank 21 by referencing Fig. 3, which illustrates a schematic diagram of another example of the liquid cooling tank. The liquid cooling tank 100 illustrated in Fig. 2 is an example of forced-circulation cooling using the pump 23. Contrastingly, a liquid cooling tank 300 illustrated in Fig. 3 is an example of natural cooling where a heat sink 27 is thermally connected to one side wall of the liquid cooling tank 21, and the heat sink 27 absorbs heat from the second refrigerant through the side wall.

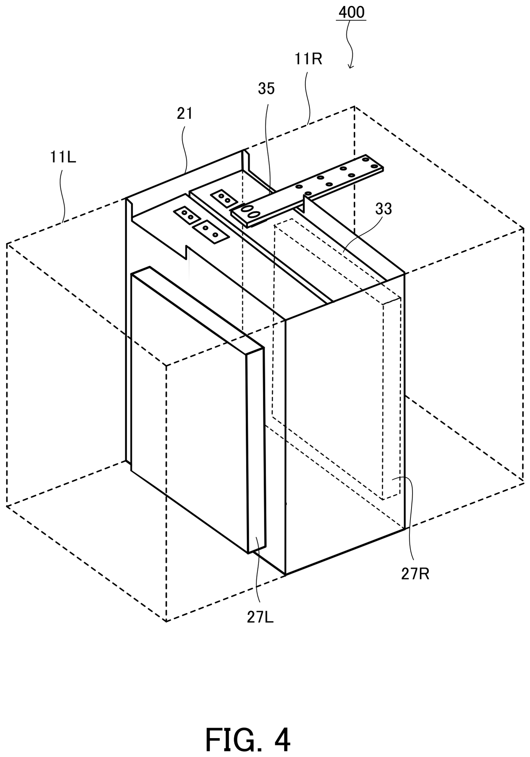

The following describes a modification as a combination of the first liquid cooling tank (liquid cooling tank 11) and the second liquid cooling tank (liquid cooling tank 21) by referencing Fig. 4, which illustrates a schematic diagram of another example of the liquid cooling tank. In the illustrated example of a liquid cooling tank 400, the liquid cooling tank 11 is composed of a right liquid cooling tank 11R and a left liquid cooling tank 11L, which are positioned to sandwich the centered liquid cooling tank 21 on both sides. In terms of side walls separating the right liquid cooling tank 11R or the left liquid cooling tank L from the liquid cooling tank 21, the side wall of the right liquid cooling tank 11R or the left liquid cooling tank L and the side wall of the liquid cooling tank 21 may share a single partition wall or may adjoin. In the illustrated example of the liquid cooling tank 400, the right liquid cooling tank 11R and the liquid cooling tank 21 share a single partition, and the left liquid cooling tank 11L and the liquid cooling tank 21 also share a single partition. Heat sinks 27R and 27L are thermally connected to the surface of one shared partition wall toward the right liquid cooling tank 11R, and the surface of the other shared partition wall toward the left liquid cooling tank 11L, respectively. The heat sinks 27R and 27L absorb heat from the second refrigerant through the side walls.

As illustrated in Figs. 2 through 4, it is possible to use a system where a heat dissipation mechanism for cooling the second refrigerant contained in the second liquid cooling tank 21 is placed in the first liquid cooling tank 11 and the first refrigerant contained in the first liquid cooling tank 11 absorbs heat. It just needs to install fewer heat exchangers than the total number of liquid cooling tanks (two) for each refrigerant outside the first liquid cooling tank 11, making it possible to save facilities and space required for installation.

The following describes a more favorable example of waterproofing treatment on the electronic printed circuit board 31 by referencing Figs. 5 and 6.

In the example illustrated in Fig. 5, the waterproofed electronic printed circuit board 31 is structured to include the electronic printed circuit board 31, including a printed circuit board 311 and one or more heat-generating elements 312 (CPU or GPU) mounted on the printed circuit board 311; a non-conductive bag 41 for enclosing the electronic apparatus 31; the heat sink 31a; and a bonding layer 51 that connects the back surface of the heat sink 31a to one side of the non-conductive bag 41 in a watertight manner. The bonding layer 51 is formed from a heterogeneous-material bonding film. A first opening is formed in the heterogeneous-material bonding film. The first opening provides a window for thermally connecting the back surface of the heatsink 31a to one side of one or more first heat-generating elements.

The non-conductive bag 41 is made of a synthetic resin film (such as polyethylene, polypropylene, or polyester) that is water-resistant and relatively heat-resistant (100°C or more, for example) and can maintain hermeticity (airtightness/watertightness) when sealed. A zipper mechanism (unshown) is provided for one side of the non-conductive bag 41. The zipper mechanism 20 may be configured so that the zipper, when opened, enables the printed circuit board 311 to be placed in the non-conductive bag 41 and, when closed, maintains hermeticity of the non-conductive bag 41. In addition, a check valve (unshown) may be provided for one surface of the non-conductive bag 41. The check valve provides a path for vacuumizing inside the non-conductive bag 41 and maintains hermeticity during and after the vacuumization.

A size of the heterogeneous-material bonding film is favorably slightly larger than or equal to the size of the heatsink 31a. The size of the first opening, comparable to the window, is favorably slightly larger than or equal to the size of the heat-generating element 312. A second opening is also favorably formed in the non-conductive bag 41. The size of the second opening formed in the non-conductive bag 41 may be as large as the first opening formed in the heterogeneous-material bonding film. The size of the first and second openings provide a common window to thermally connect the back surface of the heatsink 31a with one surface of the heat-generating element 312.

Examples of the heterogeneous-material bonding film to form the bonding layer 51 include the "Metaseal" series (a Fujimori Kogyo product name) manufactured by Fujimori Kogyo Co., Ltd. The uniformly thick heterogeneous-material bonding film is sandwiched between the back surface of the heatsink 31a and the exterior of the non-conductive bag 41. Then, heat and pressure are applied to the heterogeneous-material bonding film to form the bonding layer 51 that bonds the heatsink 31a and the non-conductive bag 41. A heat press or iron-type heater can be used for heat-press bonding to complete the bonding between the heatsink 31a and the non-conductive bag 41 easily and quickly (in a few seconds). The bonding layer 51 can be formed by not only heat-press bonding but also various methods, such as pressure, ultrasonic waves, electromagnetic waves, and light irradiation.

The bonding layer 51, formed of a heterogeneous-material bonding film, can provide a surface bond between the back surface of the heatsink 31a and the exterior of the non-conductive bag 41 while ensuring uniform adhesive strength and film thickness. The bonding layer 51 can be used for firm bonding between the heat sink and the bag.

It is also possible to use "WelQuick" (a Resonac Corporation product name), as another example of heterogeneous-material bonding films for forming the bonding layer 51. This heterogeneous-material bonding film utilizes a solid-liquid phase change of the film material, making it possible not only to complete a bonding process quickly (in a few seconds) but also to peel and re-bond the film by reheating after bonding. It is possible to facilitate a process of recovering the waterproofed electronic printed circuit board 31 after a predetermined period of use, and removing the heatsink 31a from the non-conductive bag 41. High resource reusability can be expected.

One surface of the heat-generating element 312 makes surface contact with and thermally connects to the back surface of the heatsink 31a through the windows formed in the non-conductive bag 41 and the heterogeneous-material bonding film. To ensure surface contact and thermal connection, it is advantageous to fill the minute gap between one surface of the heat-generating element 312 and the back surface of the heatsink 31a with thermal conductive grease 313.

In another example shown in Fig. 6, the waterproofed electronic printed circuit board 31 is structured similarly to the example shown in Fig. 5, but differs from it in that the bonding layer 51 provides a watertight connection between the surface of the heatsink 31a and the interior of the non-conductive bag 41; a first opening formed in the heterogeneous-material bonding film and a second opening formed in the non-conductive bag provide windows for exposing a fin area 314 of the heatsink 31a to the outside of the non-conductive bag 41; and a back surface 331b of the heatsink inside the non-conductive bag 41 provides a connecting surface thermally connected to one side of one or more heat-generating elements 312.

According to the waterproofed electronic printed circuit board 31 illustrated in Figs. 5 and 6, the first refrigerant directly absorbs heat from the heat sink surface, and the heat sink locally and powerfully absorbs heat from the heat-generating element thermally connected to the back surface of the heat sink. A bonding layer formed from a heterogeneous-material bonding film can provide a strong and stable watertight bond between the back surface of the heat sink and one surface of the bag.

When the inside of a non-conductive bag is vacuumized to seal it, the interior of the non-conductive bag closely contacts both sides of the printed circuit board and the surfaces of the various electronic components mounted on the printed circuit board. It is possible to increase the efficiency of heat removal from various electronic components, thereby further improving the cooling performance of the electronic printed circuit board.

There may be a case where the liquid cooling tank, composed of the first liquid cooling tank containing the first refrigerant and the second liquid cooling tank containing the second refrigerant, is supplemented with a third liquid cooling tank containing a third refrigerant different from the first and second refrigerants. Obviously, this case is also encompassed in the scope of protection of the patent as long as the requirements described in the claims are satisfied.

The present invention can be broadly applied to technologies that immerse the computer system, including two or more heat-generating elements, in a conductive refrigerant, such as ordinary water, tap water, or seawater, or a non-conductive refrigerant for cooling.

### REFERENCE SIGNS LIST

- 11, 11R, 11L: liquid cooling tank (first liquid cooling tank)
- 11a: refrigerant inlet
- 11b: refrigerant outlet
- 13: pump
- 13a: inlet
- 13b: outlet
- 15: heat exchanger
- 15a: cooled refrigerant inlet
- 15b: cooled refrigerant outlet
- 15c: cooling refrigerant inlet
- 15d: cooling refrigerant outlet
- 21: liquid cooling tank (second liquid cooling tank)
- 21a: refrigerant inlet
- 21b: refrigerant outlet
- 23: pump
- 25: radiator
- 30: computer system
- 31: electronic printed circuit board
- 311: printed circuit board
- 312: heat-generating element
- 313: thermal conductive grease
- 31a: heatsink
- 314: fin area
- 32a, 32b: DC voltage input terminals
- 33: PSU
- 34a,: 34b DC voltage output terminals
- 35: bus bar (conductive path)
- 36: connector terminal
- 41: non-conductive bag
- 51: bonding layer
- 100, 300, 400: liquid cooling tank

## Claims

1. A method for cooling a computer system including two or more heat-generating elements, comprising:
dividing the computer system into a first segment including one or more first heat-generating elements and a second segment including one or more second heat-generating elements;
waterproofing the first segment by covering the first segment with a waterproof film or a waterproof bag;
electrically connecting the waterproofed first segment to the unwaterproofed second segment;
immersing the waterproofed first segment in a first liquid cooling tank containing a first refrigerant; and
immersing the unwaterproofed second segment in a second liquid cooling tank containing a second refrigerant different from the first refrigerant.

2. The cooling method according to claim 1, wherein
the first segment includes an electronic printed circuit board where various electronic components are mounted, and wherein the first heat-generating element includes one or more central processing units (CPUs) or graphics processing units (GPUs).

3. The cooling method according to claim 1, wherein
the second segment includes a power supply unit (PSU); and wherein a second heat-generating element includes one or more voltage converters or power semiconductors.

4. The cooling method according to claim 1, wherein the first refrigerant is water; and wherein the second refrigerant is a non-conductive synthetic oil, mineral oil, or silicone oil.

5. The cooling method according to claim 1, wherein a supply terminal of the waterproofed first segment and a supply terminal of the unwaterproofed second segment are electrically connected via a conductive path.

6. The cooling method according to claim 1, wherein the conductive path is a bus bar or an electrical cable.

7. The cooling method according to claim 1, wherein the first liquid cooling tank and the second liquid cooling tank are each formed of a bottom wall and one or more side walls; and wherein the second liquid cooling tank is placed in the first liquid cooling tank.

8. The cooling method according to claim 1, wherein the first liquid cooling tank is formed of a bottom wall and one or more side walls; and wherein the second liquid cooling tank is formed by placing a partition wall in the first liquid cooling tank.

9. The cooling method according to claim 1, wherein the first liquid cooling tank and the second liquid cooling tank are each formed of a bottom wall and one or more side walls; and wherein the first liquid cooling tank and the second liquid cooling tank are positioned so that one side wall of the second liquid cooling tank and one side wall of the first liquid cooling tank share one partition wall or adjoin.

10. The cooling method according to claim 1, wherein a heat dissipation mechanism for absorbing heat from the second refrigerant in the second liquid cooling tank is placed in the first liquid cooling tank.

11. The cooling method according to claim 10, wherein the heat dissipation mechanism is a heat sink thermally connected to one or more side walls or partition walls of the second liquid cooling tank.

12. The cooling method according to claim 10, wherein the heat dissipation mechanism is a radiator or heat exchanger provided for a second refrigerant route connecting a refrigerant inlet and a refrigerant outlet provided for the second liquid cooling tank; and wherein the second refrigerant route is provided with a second pump for forcibly circulating the second refrigerant.

13. The cooling method according to claim 1, wherein a first pump and a heat exchanger for forcibly circulating the first refrigerant are provided for a first refrigerant route connecting a refrigerant inlet and a refrigerant outlet provided for the first refrigerant bath.

14. The cooling method according to claim 1, wherein
the waterproofed first segment includes:
an electronic apparatus including an electronic printed circuit board and one or more heat-generating elements mounted on the electronic printed circuit board;
a non-conductive bag for enclosing the electronic apparatus;
a heat sink; and
a bonding layer for connecting a back surface of the heat sink to one side of the non-conductive bag in a watertight manner; wherein
the bonding layer is formed from a heterogeneous-material bonding film; wherein
a first opening is formed in the heterogeneous-material bonding film; and wherein
the first opening provides a window for thermally connecting the back surface of the heat sink to one side of the one or more first heat-generating elements.

15. The cooling method according to claim 1, wherein the waterproofed first segment includes:
an electronic apparatus including an electronic printed circuit board and one or more heat-generating elements mounted on the electronic printed circuit board;
a non-conductive bag for enclosing the electronic apparatus;
a heat sink; and
a bonding layer for connecting the heat sink surface to an interior of the non-conductive bag in a watertight manner, wherein
the bonding layer is formed from a heterogeneous-material bonding film; wherein
a first opening is formed in the heterogeneous-material bonding film; wherein a second opening is formed in the non-conductive bag; wherein the first opening and the second opening provide windows for exposing a fin area of the heat sink to the outside of the non-conductive bag; and wherein the back surface of the heat sink, placed inside the non-conductive bag, provides a connecting surface thermally connected to one side of the one or more heat-generating elements.

16. A method for cooling a computer system comprising:
dividing a computer system, including two or more heat-generating elements, into a first segment, including one or more first heat-generating elements, and a second segment, including one or more second heat-generating elements;
electrically connecting the first and second segments;
immersing the first segment in a first liquid cooling tank containing a first refrigerant; and
immersing the second segment in a second liquid cooling tank containing a second refrigerant different from the first refrigerant.

17. A liquid cooling tank for cooling a first segment, including one or more first heat-generating elements, and a second segment, including one or more second heat-generating elements, each segment being divided from a computer system including two or more heat-generating elements, using different refrigerants, comprising:
a first liquid cooling tank for containing a first refrigerant;
a second liquid cooling tank for containing a second refrigerant different from the first refrigerant; and
a heat dissipation mechanism that is placed in the first liquid cooling tank and absorbs heat from the second refrigerant in the second liquid cooling tank.

18. The liquid cooling tank according to claim 17, wherein the first refrigerant is water and the second refrigerant is a non-conductive synthetic oil, mineral oil, or silicone oil.

19. The liquid cooling tank according to claim 17, wherein the heat dissipation mechanism is a heat sink thermally connected to one or more side walls or partition walls of the second liquid cooling tank.

20. The liquid cooling tank according to claim 17, wherein the heat dissipation mechanism is a radiator or a heat exchanger provided for a second refrigerant route connecting a refrigerant inlet and a refrigerant outlet provided for the second liquid cooling tank.

21. The liquid cooling tank according to claim 20, wherein the second refrigerant route is provided with a second pump for forcibly circulating the second refrigerant.

22. The liquid cooling tank according to claim 17, wherein a heat exchanger is provided for a first refrigerant route connecting a refrigerant inlet and a refrigerant outlet provided for the first refrigerant tank.

23. The liquid cooling tank according to claim 22, wherein the first refrigerant route is provided with a first pump for forcibly circulating the first refrigerant.
